Europäisches Patentamt

European Patent Office

Office européen des brevets

(19)

(11) Veröffentlichungsnummer: **0 245 755**
**B1**

# (12) EUROPÄISCHE PATENTSCHRIFT

(45) Veröffentlichungstag der Patentschrift:
07.11.90

(21) Anmeldenummer: 87106507.4

(22) Anmeldetag: 05.05.87

(51) Int. Cl.⁵: **G01R 33/38, H01F 7/20**

(54) **Elektromagnetsystem für die Kernspintomographie.**

(30) Priorität: 13.05.86 DE 3616078

(43) Veröffentlichungstag der Anmeldung:
19.11.87 Patentblatt 87/47

(45) Bekanntmachung des Hinweises auf die Patenterteilung:
07.11.90 Patentblatt 90/45

(84) Benannte Vertragsstaaten:
DE FR GB NL

(56) Entgegenhaltungen:
EP-A- 0 111 219
EP-A- 0 160 350
EP-A- 0 187 691
DE-C- 1 229 187
US-A- 4 122 386

REVIEW OF SCIENTIFIC INSTRUMENTS, Band 32, Nr. 3,
März 1961, Seiten 241-250, American Institute of
Physics, New York, US; W.A. ANDERSON: "Electrical
current shims for correcting magnetic fields"
DIAGNOSTIC IMAGING, Band 54, Nr. 10, Oktober 1985,
Seiten 134-139, Basel, CH; W.R. BRODY: "New design
may invigorate resistive magnet technology"

(73) Patentinhaber: Bruker Analytische Messtechnik GmbH,
Silberstreifen, D-7512 Rheinstetten-Forchheim(DE)

(72) Erfinder: Müller, Wolfgang, Dr. habil. Dipl.-Phys.,
Kösliner Strasse 48a, D-7500 Karlsruhe 1(DE)
Erfinder: Laukien, Günther R.,Prof. Dr. Dipl.-Phys., Am
Silberstreifen 8, D-7512 Rheinstetten 4(DE)

(74) Vertreter: Patentanwälte Kohler - Schwindling - Späth,
Hohentwielstrasse 41, D-7000 Stuttgart 1(DE)

**Beschreibung**

Die Erfindung betrifft ein Elektromagnetsystem für die Kernspintomographie mit einem ferromagnetischen Joch, zwei am Joch angeordneten, mit ihren Polflächen einander gegenüberstehenden Polstükken, die zwischen sich einen Luftspalt mit einem Durchmesser/Breitenverhältnis von weniger als 2,5 definieren und mit mindestens einer Erregerspule, die im Luftspalt ein Magnetfeld erzeugt, dessen Homogenität in einem kugelförmigen Volumen mit einem Durchmesser der halben Breite besser als $10^{-4}$ ist.

Ein derartiges System, das die gennanten Eigenschaften aufweisen soll, ist in der US-Z-Diagnostic Imaging, October 1985, S. 134 bis 139, beschrieben.

Bei der Kernspintomographie wird für medizinische und biologische Untersuchungen ein menschlicher oder tierischer Körper ganz oder abschnittsweise gleichzeitig einem starken, homogenen Konstantmagnetfeld und zusätzlich einem dazu senkrecht gerichteten Hochfrequenzfeld ausgesetzt. Durch bekannte Aufnahmetechniken ist es nun möglich, in bestimmten Bereichen des Körpers, insbesondere in Querschnittsebenen des Körpers, Kernresonanzen anzuregen und aus den empfangenen Kernresonanzsignalen eine Bilddarstellung der betreffenden Querschnittsfläche zu erzeugen. Diese Bilddarstellung gestattet ohne jegliche schädliche Nebenwirkungen auf den zu untersuchenden Körper eine kontrastreiche Darstellung von Weichteilen, Flüssigkeiten und dergleichen.

Für Kernspintomographen, mit denen die vorstehend beschriebene Meßmethode durchgeführt wird, sind somit Magnetsysteme erforderliche, die in einem relativ großen Volumen ein räumlich und zeitlich konstantes Magnetfeld erzeugen. Typischerweise ist es erforderlich, in einem kugelförmigen Volumen eines Durchmessers von 10 cm oder mehr ein Magnetfeld einer Stärke von 0,1 bis 5 Tesla und einer Homogenität von besser als $10^{-4}$ zu erzeugen.

Hierzu ist es bekannt, reine Luftspulensysteme normalleitender und supraleitender Art zu verwenden, es ist aber auch, beispielsweise aus der eingangs genannten Zeitschrift, bekanntgeworden, Elekromagnetsysteme mit Eisenkern zu verwenden, um Magnetfelder der genannten Art zu erzeugen.

In der allgemeinen Literatur über Elektromagnete werden zahlreiche Konfigurationen derartiger Elektromagnete beschrieben, wie sie für allgemeine elektrotechnische Aufgaben, aber auch Aufgaben in der Physik, beispielsweise der Kernphysik, verwendet werden.

Es sind auch zahlreiche Vorschläge bekanntgeworden, Elektromagnetsysteme mit Eisenkernen für klassische Kernresonanzexperimente zu verwenden, bei denen eine Probensubstanz in einem Probenröhrchen einem Kernresonanzexperiment unterzogen wird. Da das Probenvolumen bei derartigen klassischen Kernresonanzexperimenten sehr gering ist, ist die Erzeugung des erforderlichen sehr homogenen Magnetfeldes nicht mit größeren Schwierigkeiten verbunden, wenn man ein Elektromagnetsystem mit Eisenkern verwenden will, weil das Verhältnis des Polschuhdurchmessers zum Luftspalt ohne weiteres einen Betrag von 5 oder mehr erreichen kann. Je größer jedoch dieses Verhältnis ist, desto größer ist auch die Homogenität im Luftspalt zwischen den Polflächen der Polschuhe.

Will man hingegen einen menschlichen oder tierischen Körper abschnittsweise oder ganz dem konstanten Magnetfeld aussetzen, benötigt man hierzu Luftspalte einer Breite von mindestens 20 cm, typischerweise sogar 50 cm. Will man für diesen Fall Verhältnisse herstellen, wie sie bei den gennanten klassischen Kernresonanzexperimenten mit Probenröhrchen vorlagen, wollte man also ein Verhältnis des Polschuhdurchmessers zum Luftspalt von 5 oder mehr einstellen, würde man bei einem Luftspalt von 50 cm Breite einen Polschuhdurchmesser von 2,5 m erhalten, eine Abmessung, die realistischerweise nicht mit Eisenmagneten nicht darstellbar ist.

Um diesen Problem zu begegnen, hat man sich bereits früher Gedanken gemacht, wie durch Formgebung der Polstücke oder der vorne auf diese aufgesetzten Polschuhe eine Homogenitätsverbesserung im Luftspalt erreicht werden kann, ohne den Polschuhdurchmesser zu groß dimensionieren zu müssen. In diesem Zusammenhang haben sich vor allem zwei Konzepte durchgesetzt.

Zum einen wurde von Rose in der US-Z-Physical Review, 53, 1938, S. 715, vorgeschlagen, den Feldstärkeabfall am äußeren Rand der Polschuhe dadurch zu vermindern, daß auf die Polfläche Ringe aus weich- oder hartmagnetischem Material aufgesetzt werden.

Zum anderen ist es aber auch allgemein bekannt gewesen, die Polschuhe am vorderen Ende konisch auszubilden, vorzugsweise so, daß sich die gedachten Spitzen der Konen beider Polschuhe in demselben Punkt befinden.

Auf diese Weise hat man zwar gegenüber unkorrigierten Polschuhen deutliche Homogenitätsverbesserungen erzielen können, für Kernresonanzexperimente, insbesondere die Kernspintomographie, reichen diese Maßnahmen alleine jedoch nicht aus, falls das Durchmesser/Breitenverhältnis kleiner als 2,5 ist.

Aus der klassischen Technik der Kernresonanzexperimente mit Proben von Probenröhrchengröße mit einem Verhältnis des Polschuhdurchmessers zur Luftspaltbreite von 5 oder mehr ist es schließlich bekannt, sog. Shimspulen zu verwenden, die gruppenweise zur Feinkorrektur von Feldgradienten verwendet werden. Derartige Shimspulen sind beispielsweise aus der US-Z-Review of Scientific Instruments, 32 (1961), S. 241-250 bekannt.

Shimspulen der dort beschriebenen Art machen sich die Überlegung zunutze, daß man das Magnetfeld im Probenraum nach Kugelflächenfunktionen entwickeln kann, um dann für jeden Koeffizienten der dreidimensionalen Reihenentwicklung eine passende Gruppe von Shimspulen vorzusehen, die diesen und nur diesen Koeffizienten beeinflußt, während sie das senkrecht zu den Polflächen gerichtete Magnetfeld dem Betrage nach nicht verändern. Diese Anordnung von Shimspulen wird in der Fachwelt als "orthogonal" bezeichnet. Die Orthogonalität dieser Shimspulen ist für Kernresonanzexperimente von höchster Wichtigkeit, weil beim "Shimmen" des Magnetfeldes, d.h. bei der Feinkorrektur der Homogenität, selbstverständlich der Grundwert des Magnetfeldes nicht verändert werden soll, weil dies zu einem Wandern der Spektrallinien im Kernresonanzexperiment führen würde.

In der Praxis verfügt der Benutzer eines Kernresonanzspektrometers über eine Referenzprobe mit einer besonders ausgeprägten sehr schmalen Spektrallinie, die zunächst in das Kernresonanzspektrometer eingesetzt wird. Mittels einer Vielzahl von Einstellorganen für die verschiedenen Sätze von Shimspulen werden nun die einzelnen Gradienten des Magnetfeldes nacheinander so mit Erregerstrom gespeist, daß sich letztendlich eine optimale Feinkorrektur des Magnetfeldes bis zu Homogenitäten von $10^{-9}$ ergibt.

Die hierzu verwendeten Ampèrewindungszahlen zum Erregen der Shimspulen liegen im Bereich von 10 ppm ($10^{-6}$) der Ampèrewindungszahl der Haupterregerspule.

Bei der Konzeption von Elektromagnetsystemen mit Eisenkern geht man üblicherweise von einer rotationssymmetrischen Ausbildung der Erregerspulen und des Polschuhes aus. Man kann den Feldverlauf in der Nähe des Symmetriezentrums in einer Richtung senkrecht zu den Polflächen durch die folgende Reihenentwicklung darstellen:

$$B_z = B_0 + b_2 \cdot z^2 + b_4 \cdot z^4 + b_6 \cdot z^6 + \ldots$$

Die ungeraden Terme dieser Reihenentwicklung fehlen aufgrund der vorausgesetzten Symmetrie des Elektromagnetsystems. Während nun bei großen Verhältnissen des Polschuhdurchmessers zur Luftspaltbreite von beispielsweise 5 oder mehr die Koeffizienten $b_i$ klein sind, so daß sind im Zentrum ein annähernd homogenes Feld ergibt, gilt dies dann nicht mehr, wenn diese Verhältnisse infolge großer Luftspaltbreiten bei nicht gleichzeitig erhöhtem Polschuhdurchmesser kleiner werden, beispielsweise einen Wert von 2,5 oder weniger einnehmen.

Durch die weiter obengenannten Maßnahmen zur Beeinflussung der Form der Polschuhe kann man nun im Hinblick auf die oben angeführte Reihenentwicklung erreichen, daß der Koeffizient $b_2$ wenigstens näherungsweise zu Null gemacht wird. Dann kann man den Feldverlauf im Zentrum des Elektromagnetsystems durch eine Parabel vierter und höherer Ordnung beschreiben. Während, wie erwähnt, diese Koeffizienten vierter Ordnung bei großen Öffnungsverhältnissen so klein sind, daß sie im vorliegenden Zusammenhang nicht oder wenig stören würden, gilt dies bei kleinen Öffnungsverhältnissen von 2,5 oder weniger nicht mehr.

Auch die weiter obengenannten Shimspulen klassischer Art zur Feinkorrektur der Homogenität des Magnetfeldes sind dann zur Homogenisierung bei kleinen Öffnungsverhältnissen nicht mehr geeignet, weil ihr Einfluß auf die Homogenität des Magnetfeldes um Größenordnungen kleiner ist als die Inhomogenität, die sich durch das kleine Öffnungsverhältnis mit nicht-verschwindenden Koeffizienten vierter und höherer Ordnung ergibt.

Der Erfindung liegt daher die Aufgabe zugrunde, ein Elektromagnetsystem der eingangs genannten Art dahingehend weiterzubilden, daß Elektromagnetsysteme mit ferromagnetischem Kern bei vertretbaren Abmessungen zur Verfügung gestellt werden können, die bei kleinem Öffnungsverhältnis von 2,5 oder weniger eine Homogenität von $10^{-4}$ oder besser in einem Volumen mit einem Durchmesser von mindestens der halben Breite des Luftspaltes erreichen.

Diese Aufgabe wird erfindungsgemäß dadurch gelöst, daß im Bereich der Ebene der Polflächen jeweils eine im wesentlichen flächenhafte Zusatzspule angeordnet ist, deren Ampère-Windungszahl zwischen 0,1 % und 10 % der Ampère-Windungszahl der Erregerspule beträgt.

Die der Erfindung zugrundeliegende Aufgabe kann damit vollkommen gelöst werden, weil die Zusatzspule im Bereich der Ebene der Polflächen bei der genannten Ampère-Windungszahl einen deutlichen Einfuß auf die Homogenität des Magnetfeldes aufweist, so daß die durch das kleine Öffnungsverhältnis sich ergebende Inhomogenität kompensiert werden kann.

Die Dimensionierung und Positionierung der Zusatzspulen erfolgt nach Grundlagen, wie sie beispielsweise in dem Buch "Solenoid Magnet Design" von Montgomery, Wiley-Interscience, New York, angegeben sind. Zunächst wird der Feldbeitrag einer Stromschleife als Luftspule bestimmt und danach die Summe des gesamten Zusatzspulensystems durch Überlagerung berechnet. Der Einfluß des Eisens wird dabei durch die Spiegelmethode ermittelt, wobei die Ströme näherungsweise verdoppelt werden. Eine genauere Berücksichtigung des Magnetisierungsbeitrags des ferromagnetischen Materials kann mit Hilfe von an sich bekannten Berechnungsprogrammen durchgeführt werden. Diese aufwendigen Programme ergeben jedoch nicht die erforderliche Genauigkeit, die zur Beurteilung der hohen Homogenität erforderlich ist. Die endgültige Festlegung der Zusatzspulen bedarf daher experimenteller Korrekturschritte. Bei der Auslegung können zwei Kriterien zur Homogenitätsoptimierung verwendet werden. Zum einen ist es, wie oben beschrieben, möglich, die Feldentwicklung um das Symmetriezentrum durchzuführen und die Spulen so auszulegen, daß die Summe der Entwicklungskoeffizienten bis zu einer vorgegebenen Ordnung praktisch gleich Null ist. Da es das Ziel der Erfindung ist, in einem möglichst großen Bereich eine gute Homogenität zu erzielen, kann die Methode der Entwicklungskoeffizienten, die nur in der Nähe des Nullpunktes gültig ist, durch die Forderung ersetzt werden, daß über den gesamten Homogenitätsbereich die mittlere quadratische Abweichung des Feldes von einem konstanten Wert minimal wird. Diese in der Fehlerrechnung übliche Methode führt bei kleinen, relativen Homogenitätsbereichen zu vergleichbaren Ergebnissen wie die Methode der Entwicklungskoeffizienten.

Auf diese Weise ist es möglich, die Dimensionierung, Anordnung und Erregung der Zusatzspulen so einzustellen, daß die erforderliche Homogenität erreicht wird. Dabei ergeben sich Lösungen, bei denen einige Zusatzspulen mit gegensinniger Stromrichtung gegenüber der Hauptstromrichtung betrieben werden. Es versteht sich, daß in einer bevorzugten Ausgestaltung der Erfindung die Polstücke und Zusatzspulen so dimensioniert sind, daß die notwendige Homogenität durch die Gesamtkonfigurationen von Hauptfeld mit Shimringen und Korrekturspulenbeiträgen erreicht wird.

Bei allen genannten Ausführungsbeispielen der Erfindung kann das Feld der Zusatzspule - insbesondere als zur Haupt-Erregerspule koaxiale Solenoidspule - zu dem Magnetfeld der Erregerspule nicht-orthogonal sein, d.h. der Einfluß der Zusatzpule überlagert sich im Zentrum des Elektromagnetsystems dem Einfluß der Haupt-Erregerspule selbst, was jedoch nicht schadet, weil die Zusatzspule ständig erregt wird und nicht wie klassische Feinkorrektur-Shimspulen erst zu Korrekturzwecken mit variablem Strom gespeist wird.

Eine besonders bevorzugt Ausführungsform der Erfindung sieht hierzu vor, die Zusatzspulen und die Erregerspulen in Reihenschaltung mit einem gemeinsamen Netzgerät zu verbinden.

Diese Maßnahme ist von besonderem Vorteil deswegen, weil durch ständige Reihenschaltung der Zusatzspulen mit den Erregerspulen gewährleistet ist, daß die Zusatzspulen mit derselben Stromkonstanz betrieben werden, wie dies für die Erregerspulen der Fall ist. Außerdem entfällt in diesem Falle die Notwendigkeit eines gesonderten Netzgerätes für die Zusatzspule, so daß auch Aufwand eingespart wird. Auch die Regelung des Stromes wird vereinfacht, weil nur ein einziger Regelkreis erforderlich ist.

Die Anordnung der Zusatzspulen bei dem erfindungsgemäßen Elektromagnetsystem kann auf verschiedene Weisen gewählt werden. So können die Zusatzspulen bei einem Ausführungsbeispiel der Erfindung auf der Polfläche angeordnet sein, es können bei einer anderen Ausführungsform der Erfindung die Polflächen mit jeweils einer zentrischen Eindrehung versehen und die Zusatzspulen in den Eindrehungen angeordnet sein und schließlich können die Polstücke im Bereich der Ebene der Polflächen von der Zusatzspule umgeben sein.

In allen drei Fällen ist von Vorteil, daß sich der Einfluß der Zusatzspule unmittelbar in der Ebene der Polflächen auswirkt.

Es wurde bereits erwähnt, daß das erfindungsgemäße Elektromagnetsystem vorzugsweise durch Formgebung der Polschuhe in seiner Grundhomogenität optimiert wird, insbesondere durch einen Shimring aus weich- oder hartmagnetischem Material oder durch eine konische Formgebung der Polstücke.

Obwohl die Ampère-Windungszahl der Zusatzspule in weiten Bereichen variieren kann, so ist doch ein Ausführungsbeispiel der Erfindung besonders bevorzugt, bei der die Zusatzspulen von einem Strom mit einer Stärke von einigen 100 Ampère durchflossen werden.

Schließlich können bei einer Variante der Erfindung die Polstücke und die Zusatzspulen einen rechteckigen Querschnitt senkrecht zur Richtung des Magnetfeldes aufweisen.

Diese Maßnahme hat den an sich bekannten Vorteil, daß beispielsweise durch langgestreckte rechteckige QuerschnittsFormgebung ein Magnetfeld einer großen Ausdehnung senkrecht zur Richtung des Konstantmagnetfeldes erzeugt werden kann, um in dem langgestreckten Körper eines Patienten über eine große Länge ein homogenes Magnetfeld zu erzeugen und so Ganzkörperaufnahmen zu ermöglichen, ohne den Patienten relativ zum Magnetfeld bewegen zu müssen.

Weitere Vorteile der Erfindung ergeben sich aus der Beschreibung und der beigefügten Zeichnung.

Es versteht sich, daß die vorstehend angegebenen und die nachstehend noch geschilderten Merkmale nicht nur in der jeweils angegebenen Kombination, sondern auch in anderen Kombinationen oder auch in Alleinstellung verwendet werden können, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:

Fig. 1 eine Gesamtansicht eines erfindungsgemäßen Elektromagnetsystems, teilweise aufgebrochen, mit einem H-förmigen ferromagnetischen Joch;

Fig. 2 eine Darstellung, ähnlich Fig. 1, jedoch mit einem schalenkernartigen Joch;

Fig. 3 eine Darstellung, ähnlich den Fig. 1 und 2, jedoch mit einem C-förmigen Joch;

Fig. 4 eine Querschnittsdarstellung, in vergrößertem Maßstab, des Bereiches der Polstücke eines Ausführungsbeispiels eines erfindungsgemäßen Elektromagnetsystems;

Fig. 5 einen schematischen Stromlaufplan zur Erläuterung der elektrischen Verschaltung eines erfindungsgemäßen Elektromagnetsystems;

Fig. 6 eine Darstellung, teilweise ähnlich Fig. 4, für eine weitere Formgebung eines erfindungsgemäßen Elektromagnetsystems;

Fig. 7 eine Schnittdarstellung, in weiter vergrößertem Maßstab, zur Erläuterung eines weiteren Ausführungsbeispiels der Erfindung;

Fig. 8a und 8b zwei Ansichten einer Anordnung von Zusatzspulen bei einem weiteren Ausführungsbeispiel der Erfindung;

Fig. 9 eine graphische Darstellung der Feldabweichung über zwei Koordinaten zur Erläuterung der Wirkung der Erfindung, verglichen mit dem Stand der Technik.

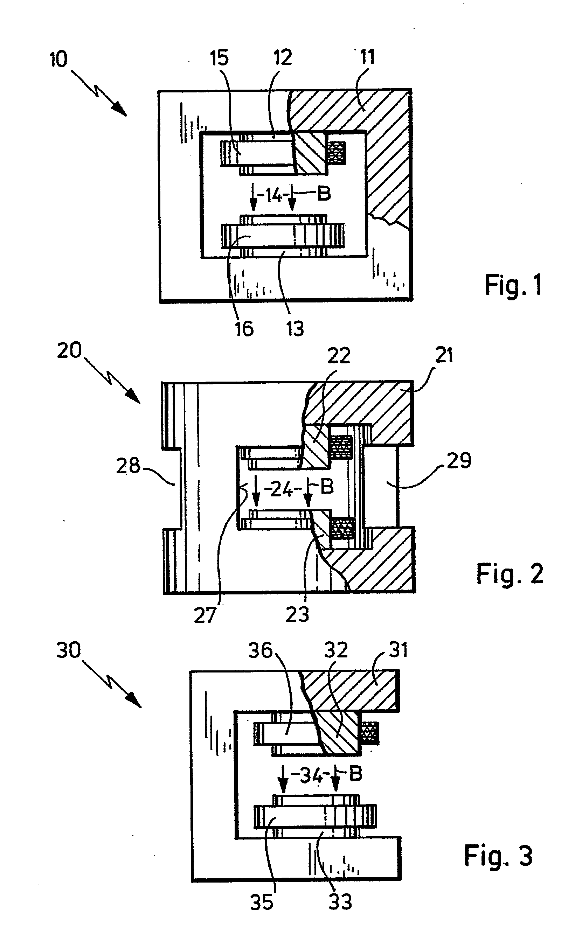

In Fig. 1 bezeichnet 10 insgesamt ein Magnetsystem mit einem ferromagnetischen Joch 11 in H-Konfiguration, das in seinem Zentrum Polstücke 12, 13 aufweist, die zwischen sich einen Luftspalt 14 definieren. Die Polstücke 12, 13 sind mit Erregerspulen 15, 16 bewickelt, so daß sich im Luftspalt 14 ein Magnetfeld B senkrecht zur Polfläche der Polstücke 12, 13 ausbildet.

Bei der Darstellung gemäß Fig. 1 ist das Joch 11 im Querschnitt rechteckförmig und die Polstücke 12, 13 sind im Querschnitt kreisförmig, es versteht sich jedoch, daß diese Formgebung nur beispielhaft zu verstehen ist und daß auch andere Querschnittsformen verwendet werden können, ohne daß dies den Rahmen der Erfindung verläßt.

Bei einem besonders bevorzugten Ausführungsbeispiel eines Magnetsystems der Konfiguration gemäß Fig. 1 ist das Joch 11 beispielsweise plattenförmig ausgebildet, so daß es auch in der Ebene senkrecht zur Darstellung gemäß Fig. 1 weit über die Polstücke 12, 13 und die Erregerspulen 15, 16 herausragt.

In Fig. 2 ist ein weiters Ausführungsbeispiel eines Magnetsystems dargestellt, das gesamthaft mit 20 bezeichnet ist. Ein Joch 21 des Magnetsystems 20 ist von schalenkernartigem Aufbau, d.h. in der Draufsicht kreisförmig. In der Hochachse des Jochs 21 befinden sich Polstücke 22, 23, die wiederum zwischen sich einen Luftspalt 24 definieren. Über den Umfang des Außenmantels des Jochs 21 sind Fenster 27, 28, 29 angebracht, durch die ein Patient in den Bereich des Luftspalts 24 eingeschoben werden kann, um ihn dort dem Einfluß des Magnetfeldes B auszusetzen. Außerdem ist durch diese Fenster eine direkte Beobachtung des Patienten möglich.

Fig. 3 zeigt mit 30 ein weiteres Ausführungsbeispiel eines Magnetsystems mit einem C-förmigen Joch 31, das an seinen freien Enden mit Polstücken 32, 33 versehen ist, die wiederum einen Luftspalt 34 zwischen sich definieren. Erregerspulen 35, 36 auf den Polstücken 32, 33 erzeugen wiederum ein Magnetfeld B.

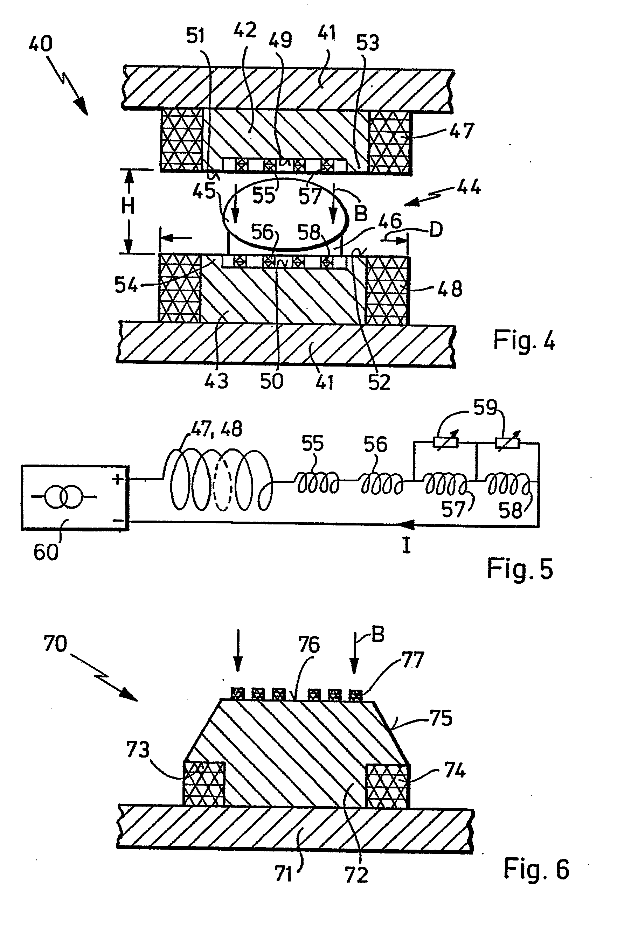

Fig. 4 zeigt in vergrößertem Maßstab für ein Ausführungsbeispiel ähnlich Fig. 1 ein Magnetsystem 40 mit plattenartigem Joch 41, das nur abgebrochen angedeutet ist. Zylindrische oder quaderförmige Polstücke 42, 43 definieren zwischen sich einen Luftspalt 44 eines Durchmessers bzw. einer Seitenlänge D und einer Breite H. Man erkennt aus der Darstellung gemäß Fig. 4, daß das Verhältnis D/H relativ klein ist, für die hier interessierenden Anwendungen kann es beispielsweise 2,5 oder 2 betragen. Auf diese Weise ist es möglich, bei vertretbarem Durchmesser D eine Luftspaltbreite H von 40 oder mehr Zentimetern zu erreichen, die genügend groß ist, damit ein mit 45 abgedeuteter Patient auf einer Liege 46 in den Bereich des Luftspalts 44 gebracht werden kann.

Um die Polstücke 42, 43 herum sind wiederum Erregerspulen 47, 48 angeordnet, so daß im Luftspalt 44 wiederum das Magnetfeld B erzeugt wird.

In der Darstellung gemäß Fig. 4 ist ferner zu erkennen, daß die Polstücke 42, 43 mit zentrischen Eindrehungen 49, 50 versehen sind, in denen Zusatzspulen 55, 56, 57, 58 im Bereich der Polflächen 51, 52 angeordnet sind. Aufgrund dieser Eindrehungen 49, 50 entstehen im Randbereich der Polflächen 51, 52 sog. Ringshims 53, 54, wie sie an sich für Elektromagnete zur Erzeugung homogener Magnetfelder bekannt sind.

In Fig. 5 ist dargestellt, wie die elektrische Verschaltung der Erregerspulen 47, 48 und der Zusatzspulen 55, 56, 57, 58 vorzugsweise erfolgt. Hierzu ist ein Netzgerät 60 vorgesehen, das einen hochstabilisierten Strom I durch die in Reihe geschalteten Erregerspulen 47, 48 und die zu diesen wiederum in Reihe geschalteten Zusatzspulen 55, 56, 57, 58 schickt. Dies bedeutet, daß die Erregerspulen 47, 48 und die Zusatzspulen 55, 56 57, 58 von demselben Strom I durchflossen werden.

Zur Feinjustierung des Erregerstroms der Zusatzspulen 55, 56, 57, 58 können regelbare Widerstände 59, die jeweils parallel zu einer der Zusatzspulen 55, 56, 57, 58 angeordnet sind, vorgesehen werden. Dadurch ist es möglich, für die Stromversorgung des Magnetsystems auch dann nur eine einzige Stromquelle zu verwenden, wenn die erforderlichen Betriebsströme der Zusatzspulen 55, 56, 57, 58 geringfügig vom Betriebsstrom der Erregerspulen 47, 48 abweichen.

Bei einem Ausführungsbeispiel eines erfindungsgemäßen Magnetsystems gemäß Fig. 4 hatte das Joch 41 in einer Draufsicht gemäß Fig. 1 etwa die Abmessungen von 2,7 m Breite und 1,2 m Höhe, der Durchmesser D der zylindrischen Polschuhe 42, 43 betrug 0,96 m und die Breite H des Luftspaltes 44 betrug 0,47 m. Die Erregerspulen 47, 48 wiesen eine Ampèrewindungszahl von 2 mal 72200 Ampèrewindungen bei einem Betriebsstrom von 282 Ampère auf. Die Zusatzspulen 55, 56, 57, 58 waren in Reihe mit den Erregerspulen 47, 48 geschaltet und daher ebenfalls mit einem Erregerstrom von 282 Ampère beaufschlagt. Der Durchmesser des inneren Paares von Zusatzspulen 55, 56 betrug 0,46 m bei einer Ampèrewindungszahl von 1128 Ampèrewindungen, der Durchmesser des äußeren Paares von Zusatzspulen 57, 58 betrug 0,68 m bei einer Ampèrewindungszahl von 2256 Ampèrewindungen. Die Verschaltung erfolgte in der Weise, daß das Paar der inneren Zusatzspulen 55, 56 einen positiven und das Paar der äußeren Zusatzspulen 57, 58 einen negativen Feldbeitrag zum Hauptfeld B ergaben. Nur zum Vergleich sei in diesem Zusammenhang angemerkt, daß klassische orthogonale Shimspulen mit jeweils einzeln einstellbaren Netzgeräten zur Fein-Homogenisierung des Magnetfeldes bei einem derartigen Magnetsystem etwa zehn Ampèrewindungen aufweisen müßten.

Fig. 6 zeigt in einer Darstellung ähnlich Fig. 4, jedoch nur für eine Hälfte der dort gezeigten Elemente, ein Magnetsystem 70 mit einem ferromagnetischen Joch 71 und einem Polstück 72, das an seinem unteren Ende mit einem umlaufenden Absatz versehen ist, so daß im an das Joch 71 angesetzten Zustand eine Ringnut 73 entsteht, in der die Erregerspule 74 angeordnet ist. Am vorderen Ende läuft das Polstück 72 in ein konisches Ende 75 aus, so daß sich eine querschnittsverminderte Polfläche 76 ergibt. Auf die Polfläche 76 ist eine Zusatzspule 77 aufgesetzt.

Die besondere Eigenschaft des Magnetsystems 70 gemäß Fig. 6 liegt darin, daß aufgrund der speziellen Konfiguration im Bereich der Ringnut 73 Erregerspulen 74 mit kleinerem Durchmesser verwendet werden können, was zu einer deutlichen Leistungsreduzierung führt. Dies setzt allerdings voraus, daß die Luftspaltinduktion deutlich kleiner als die Sättigungsinduktion des verwendeten Eisens sein muß, weil in den Polstücken 72 im Bereich der Erregerspulen 74 eine Flußkonzentration stattfindet.

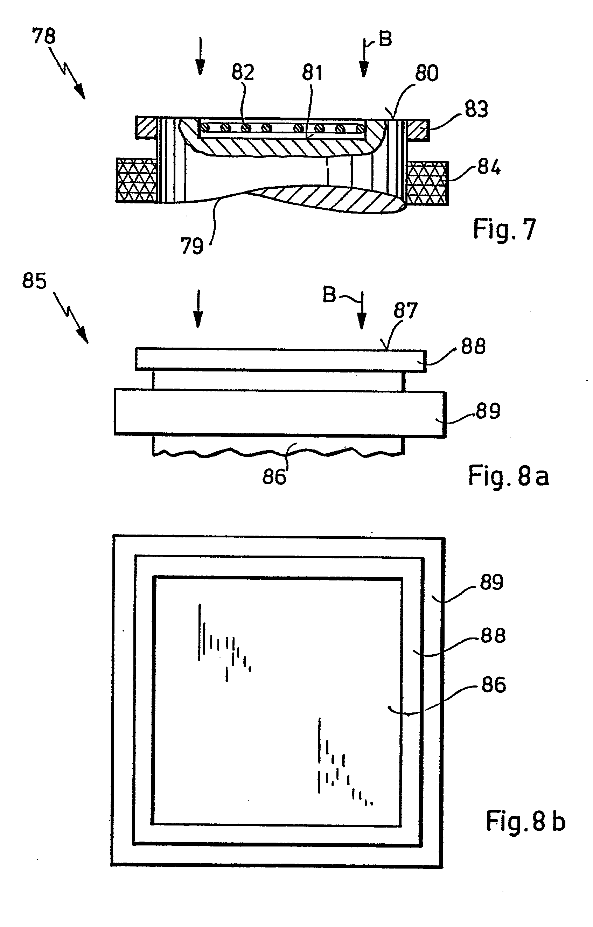

Bei einem weiteren Ausführungsbeispiel der Erfindung, wie es Fig. 7 zeigt, ist ein Magnetsystem 78 vorgesehen. dessen zylindrische Polstücke 79 im Bereich der Polfläche 80 wiederum mit einer Eindrehung 81 für eine Zusatzspule 82 versehen sind ähnlich, wie dies bereits in Fig. 4 gezeigt wurde. Im Gegensatz zum dortigen Ausführungsbeispiel ist jedoch beim Magnetsystem 78 gemäß Fig. 7 ein seitlich ausgesetzter Shimring 83 vorgesehen, der eine effektive Vergrößerung der Polfläche 87 ergibt.

Bei einem weiteren Ausführungsbeispiel eines Magnetsystems 85 gemäß Fig. 8a und 8b sind Polstücke 86 von quadratischem oder, allgemein gesprochen, von rechteckförmigem Querschnitt vorgesehen. Es ergibt sich somit auch eine quadratische Polfläche 87, die an ihren Rändern seitlich von auf die Polstücke 86 aufgesetzten Zusatzspulen 88 begrenzt wird. Erregerspulen 89 sind axial unterhalb der Zusatzspule 88 angeordnet.

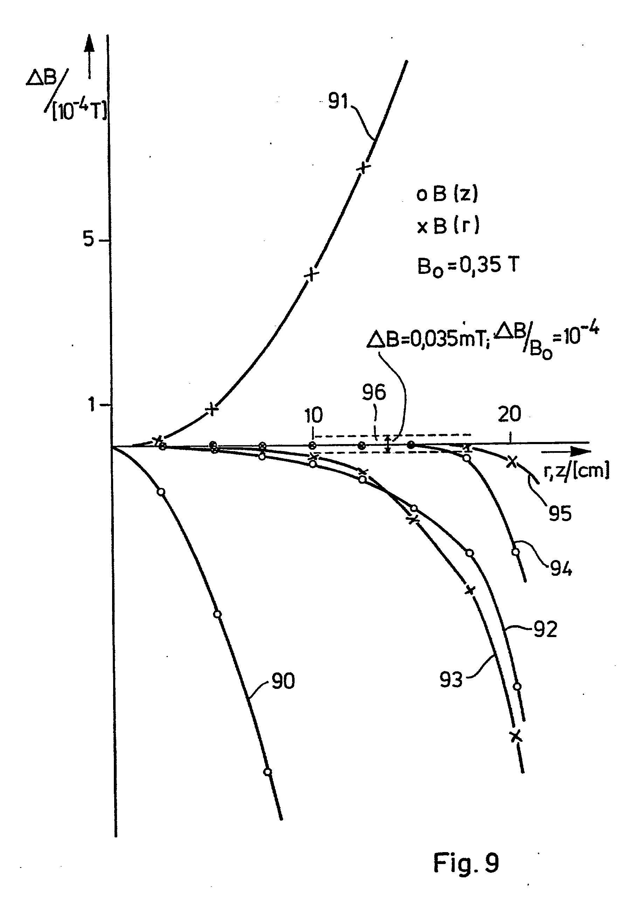

Schließlich zeigt Fig. 9 ein Diagramm zur Erläuterung der mit der vorliegenden Erfindung erzielten Wirkung.

In Fig. 9 sind paarweise jeweils die Feldabweichungen in Einheiten von $10^{-4}$ Tesla dargestellt, und zwar jeweils für den axialen Feldverlauf B(z), der mit kleinen Kreisen dargestellt ist, sowie für einen radialen Feldverlauf B (r), der mit kleinen Kreuzen dargestellt ist. Der axiale Verlauf B(z) entspricht den Größen B in den vorhergehenden Figuren. Im übrigen wurden die Verläufe gemäß Fig. 9 an einem praktischen Ausführungsbeispiel der Erfindung aufgenommen, wie es weiter oben mit Zahlenangaben zu Fig. 4 beschrieben wurde.

Die Verläufe 90, 91 in Fig. 9 zeigen zunächst die Feldabweichung für einen Polschuh mit nicht-optimierter Formgebung. Man erkennt, daß die Feldabweichungen bereits nach wenigen Zentimetern so groß sind, daß das Elektromagnetsystem für Kernresonanzexperimente völlig ungeeignet ist.

Die Verläufe 92 und 93 zeigen nun entsprechende Feldabweichungen für einen Polschuh mit optimiertem Ringshim, bei dem in guter Näherung der Koeffizient zweiter Ordnung in der Reihenentwicklung der Felder verschwindet und gleichzeitig ein Koeffizient vierter Ordnung nach Möglichkeit minimiert wurde.

Es zeigt sich jedoch, daß auch noch bei den Verläufen 92, 93 nach wenigen Zentimetern bereits große Feldabweichungen vorliegen, die Kernresonanzexperimente nicht gestatten.

Die Verläufe 94, 95 zeigen nun Messungen, wie sie mit dem zu Fig. 4 beschriebenen Ausführungsbeispiel der Erfindung unter Verwendung der dort geschilderten Zusatzspulen erzielt wurden.

Wie man leicht aus den Fig. 94, 95 sieht, wird bis zu einem Abstand von über 15 cm aus dem Zentrum des Elektromagnetsystems ein Bereich 96 nicht verlassen, der einem Homogenitätswert von etwa $10^{-4}$ entspricht. Dies bedeutet, daß Kernresonanzexperimente in einem Raumbereich möglich sind, wie er für eine Querschnittsdarstellung eines ganzen Körpers eines erwachsenen Menschen benötigt wird.

**Patentansprüche**

1. Elektromagnetsystem für die Kernspintomographie mit einem ferromagnetischen Joch (41), zwei am Joch (41) angeordnete, mit ihren Polflächen (51, 52) einander gegenüberstehenden Polstücken (42, 43), die zwischen sich einen Luftspalt (44) der Breite H definieren, und mindestens einer Erregerspule (47; 48),
dadurch gekennzeichnet,
daß der Durchmesser D der Polflächen (51, 52) höchstens gleich dem 2,5-fachen der Breite H des Luftspaltes (44) ist und im Bereich der Ebene der Polflächen (51,52) jeweils wenigstens eine im wesentlichen flächenhafte Zusatzspule (55, 56, 57, 58) angeordnet ist, deren Ampère-Windungszahl zwischen 0.1% und 10% der Ampère-Windungszahl der Erregerspule (47, 48) beträgt und deren Feld zusammen mit dem von der Erregerspule (47, 48) erzeugten Feld im Luftspalt (44) ein resultierendes Magnetfeld (B) ergibt, dessen Homogenität theoretisch in einem kugelförmigen Volumen mit einem Durchmesser der halben Breite (H) besser ist als $10^{-4}$.

2. Elektromagnetsystem nach Anspruch 1, dadurch gekennzeichnet, daß die Felder der Zusatzspulen (55, 56, 57, 58; 77; 82; 88) zu dem Magnetfeld (B) der Erregerspule (15, 16; 25, 26; 35, 36; 47, 48; 74; 84; 89) nicht-orthogonal sind.

3. Elektromagnetsystem nach einem der Ansprüche 1 oder 2, dadurch gekennzeichnet, daß die Zusatzspulen (55, 56, 57, 58; 77; 82; 88) und die Erregerspulen (15, 16; 25, 26; 35, 36; 47, 48; 74; 84; 89) in Reihenschaltung mit einem gemeinsamen Netzgerät (60) verbunden sind.

4. Elektromagnetsystem nach einem der Ansprüche 1 bis 3, dadurch gekennzeichnet, daß die Zusatzspulen (77) auf der Polfläche (76) aufliegend angeordnet sind.

5. Elektromagnetsystem nach einem der Ansprüche 1 bis 3, dadurch gekennzeichnet, daß die Polflächen (51, 52; 80) mit jeweils einer zentrischen Eindrehung (49, 50; 81) versehen und daß die Zusatzspulen (55, 56, 57, 58; 80) in den Eindrehungen (49, 50; 81) angeordnet sind.

6. Elektromagnetsystem nach einem der Ansprüche 1 bis 3, dadurch gekennzeichnet, daß die Polstücke (86) im Bereich der Ebene der Polflächen (87) von einer Zusatzspule (88) umgeben sind.

7. Elektromagnetsystem nach einem der Ansprüche 1 bis 5, dadurch gekennzeichnet, daß die Polstücke (42, 43; 79) im Bereich der Ebene der Polflächen (51, 52; 80) mit einem ferromagnetischen Shimring (53, 54; 83) versehen sind.

8. Elektromagnetsystem nach einem der Ansprüche 1 bis 6, dadurch gekennzeichnet, daß die Polstücke (72) zur Polfläche (76) hin konisch (75) verlaufen.

9. Elektromagnetsystem nach einem der Ansprüche 1 bis 8, dadurch gekennzeichnet, daß der die Zusatzpulen (55, 56, 57, 58; 77; 82; 88) durchfließende Strom (I) eine Stromstärke von einigen 100 Ampère aufweist.

10. Elektromagnetsystem nach einem der Ansprüche 1 bis 9, dadurch gekennzeichnet, daß die Polstücke (86) und die Zusatzspulen (88) einen rechteckigen Querschnitt senkrecht zur Richtung des Magnetfeldes (B) aufweisen.

## Claims

1. Electromagnetic system for nuclear spin tomography with a ferromagnetic yoke (41), two polar parts (42, 43) which are disposed at the yoke (41), have opposite polar surfaces (51, 52) and define therebetween an air gap (44) of the width H and with at least one exciter coil (47, 48), characterized in that the diameter D of the polar surfaces (51, 52) is at the most equal to 2.5 times the width H of the air gap (44) and in the vicinity of the plane of the polar surfaces (51, 52) there is disposed in each case at least an essentially laminar additional coil (55, 56, 57, 58) of which the number of ampere-turns is between 0.1% and 10% of the number of ampere-turns of the exciter coil (47, 48) and of which the field together with the field generated by the exciter coil (47, 48) yields a resulting magnetic field (B) in the air gap (44) the homogeneity of which magnetic field (B) theoretically in a spherical volume with a diameter of half width (H) is better than $10^{-4}$.

2. Electromagnetic system according to claim 1, characterized in that the fields of the additional coils (55, 56, 57, 58; 77; 82; 88) are not perpendicular to the magnetic field (B) of the exciter coil (15, 16; 25; 35, 36; 47, 48; 74; 84; 89).

3. Electromagnetic system according to one of claims 1 or 2, characterized in that the additional coils (55, 56, 57, 58; 77; 82; 88) and the exciter coils (15, 16; 25; 35, 36; 47, 48; 74; 84; 89) are connected in series to a common power supply unit (60).

4. Electromagnetic system according to one of claims 1 or 3, characterized in that the additional coils (77) are mounted on the polar surface (76).

5. Electromagnetic system according to one of claims 1 or 3, characterized in that the polar surfaces (51, 52; 80) are provided in each case with a central bore (49, 50; 81) and that the additional coils (55, 56, 57, 58; 80) are disposed in the bores (49, 50; 81).

6. Electromagnetic system according to one of claims 1 or 3, characterized in that the polar parts (86) are surrounded in the vicinity of the plane of the polar surfaces (87) by an additional coil (88).

7. Electromagnetic system according to one of claims 1 or 5, characterized in that the polar parts (42, 43; 79) are provided in the vicinity of the plane of the polar surfaces (51, 52; 80) with a ferromagnetic shim ring (53, 54; 83).

8. Electromagnetic system according to one of claims 1 or 6, characterized in that the polar parts (72) extend in a conical manner (75) to the polar surface (76).

9. Electromagnetic system according to one of claims 1 or 8, characterized in that the current (I) flowing through the additional coils (55, 56, 57, 58; 77; 82; 88) has a level of approximately 100 amperes.

10. Electromagnetic system according to one of claims 1 or 9, characterized in that the polar parts (86) and the additional coils (88) have a rectangular cross-section perpendicular to the direction of the magnetic field (B).

## Revendications

1. Système d'électro-aimant pour la tomographie à spin nucléaire, avec une culasse ferromagnétique (41), avec deux pièces polaires (42, 43) disposées sur la culasse (41) et se faisant face par leurs surfaces polaires (51, 52), en définissant entre elles un entrefer (44) de largeur H, et avec au moins une bobine d'excitation (47, 48), caractérisé par le fait que le diamètre D des surfaces polaires (51, 52) est au plus égal à 2,5 fois la largeur H de l'entrefer (44) et que dans la zone du plan des surfaces polaires (51, 52) est disposée au moins une bobine supplémentaire (55, 56, 57, 58), sensiblement plate, dont le nombre d'ampère-tours se situe entre 0,1% et 10% du nombre d'ampère-tours de la bobine d'excitation (47, 48), et dont le champ fournit, avec le champ produit par la bobine d'excitation (47, 48), un champ magnétique résultant (B) dans l'entrefer (44), dont l'homogénéité, théorique dans une volume de forme sphérique à diamètre égal à la moitié de la largeur H, est supérieur à $10^{-4}$.

2. Système d'électro-aimant selon la revendication 1, caractérisé par le fait que les champs des bobines supplémentaires (55, 56, 57, 58; 77; 82; 88) ne sont pas orthogonaux par rapport au champ magnétique (B) de la bobine d'excitation (15, 16; 25; 35, 36; 47, 48; 74; 84; 89).

3. Système d'électro-aimant selon l'une des revendications 1 ou 2, caractérisé par le fait que les bobines supplémentaires (55, 56, 57, 58; 77; 82; 88) et les bobines d'excitation (15, 16; 25; 35, 36; 47, 48; 74; 84; 89) sont reliées, en circuit série, avec un bloc d'alimentation commun (60).

4. Système d'électro-aimant selon l'une des revendications 1 ou 3, caractérisé par le fait que les bobines supplémentaires (77) sont disposées de façon à porter sur la surface polaire (76).

5. Système d'électro-aimant selon l'une des revendications 1 ou 3, caractérisé par le fait que les surfaces polaires (51, 52; 80) sont chacunes pourvues d'une gorge centrée (49, 50; 81) tournée dans la masse, et que les bobines supplémentaires (55, 56, 57, 58; 80) sont disposées dans les gorges (49, 50; 81).

6. Système d'électro-aimant selon l'une des revendications 1 ou 3, caractérisé par le fait que les pièces polaires (86) sont entourées, dans la zone du plan des surfaces polaires (87), par une bobine supplémentaire (88).

7. Système d'électro-aimant selon l'une des revendications 1 ou 5, caractérisé par le fait que les pièces polaires (42, 43; 79) sont pourvues, dans la zone du plan des surfaces polaires (51, 52; 81), d'un anneau-écran ferromagnétique (53, 53; 83).

8. Système d'électro-aimant selon l'une des revendications 1 ou 6, caractérisé par le fait que les pièces polaires (72) s'étendent coniquement (75) en direction de la surface polaire (76).

9. Système d'électro-aimant selon l'une des revendications 1 ou 8, caractérisé par le fait que le courant (I) qui passe par les bobines supplémentaires (55, 56, 57, 58; 77; 82; 88), possède une intensité de quelques centaines d'ampères.

10. Système d'électro-aimant selon l'une des revendications 1 ou 9, caractérisé par le fait que les pièces polaires (86) et les bobines supplémentaires (88) présentent, perpendiculairement à la direction du champ magnétique (B), une section transversale rectangulaire.

Fig. 1

Fig. 2

Fig. 3

Fig. 4

Fig. 5

Fig. 6

Fig. 7

Fig. 8 a

Fig. 8 b

Fig. 9